# EUROPÄISCHE PATENTANMELDUNG

(11) **EP 2 090 959 A2**
(43) Veröffentlichungstag der Anmeldung: **19.08.2009**
(21) Anmeldenummer: 08168633.9
(22) Anmeldetag: 07.11.2008
(51) Int. Cl.: G06F 1/30

(54) **Verfahren zur Stromversorgung eines Servers für ein Serverrack, Server, Serverrack, Netzteil und Anordnung mit zumindest zwei Servern**

(30) Priorität: 12.02.2008 DE 102008008600
(71) Anmelder: Fujitsu Siemens Computers GmbH, 80807 München (DE)
(72) Erfinder: Puschmann, Ralf, 33098, Paderborn (DE)
(74) Vertreter: Epping - Hermann - Fischer

(57) **Zusammenfassung**

Verfahren zur Stromversorgung eines Servers (S₁) für ein Serverrack (SR), Server (S₁), Serverrack (SR), Netzteil (N₁) zur Stromversorgung eines Servers (S₁) und Anordnung mit zumindest zwei Servern (S₁, ..., S₇)

Die Erfindung betrifft ein Verfahren zur Stromversorgung eines Servers (S₁) für ein Serverrack (SR), welcher ein Netzteil (N₁) aufweist, wobei bei einem Ausfall des Netzteils (N₁) die Stromversorgung des Servers (S₁) durch zumindest ein weiteres Netzteil (N₂) erfolgt, welches außerhalb des Servers (S₁) angeordnet ist.

Die Erfindung betrifft ebenfalls Vorrichtungen zur Ausführung des genannten Verfahrens.

## Beschreibung

Die Erfindung betrifft ein Verfahren zur Stromversorgung eines Servers für ein Serverrack.

Die Erfindung betrifft weiterhin einen Server für ein Serverrack, ein Serverrack, ein Netzteil zur Stromversorgung eines Servers sowie eine Anordnung mit zumindest zwei Servern.

Ein Netzteil in einem Server für ein Serverrack dient der Stromversorgung von Komponenten wie zum Beispiel CPUs, Festplatten oder CD-ROM-Laufwerken. Um eine Stromversorgung der Komponenten im Falle eines Ausfalls des Netzteils zu gewährleisten, wird meist ein zweites, redundantes Netzteil in dem Serverrack angeordnet.

Das redundante Netzteil setzt im Standbybetrieb Energie um, sobald es eingeschaltet ist. Selbst wenn es keinen Leistungsabnehmer mit Energie versorgt, setzt es Verlustleistung in Form von Wärme um. Die Bereitstellung der redundanten Energieversorgung führt zu einem erhöhten Energieverbrauch des Servers.

Aufgabe der Erfindung ist es, eine
Energieversorgungsredundanz für einen Server in einem Serverrack bereitzustellen, wobei der Energieverbrauch des Servers reduziert wird.

Die Aufgabe wird gelöst durch die unabhängigen Patentansprüche. Vorteilhafte Weiterbildungen sind Gegenstand der abhängigen Patentansprüche.

Gemäß einem ersten Aspekt betrifft die Erfindung ein Verfahren zur Stromversorgung eines Servers für ein Serverrack, welcher ein Netzteil aufweist, wobei bei einem Ausfall des Netzteils die Stromversorgung des Servers durch zumindest ein weiteres Netzteil erfolgt, welches außerhalb des Servers angeordnet ist.

Es ist im Server kein redundantes Netzteil nötig. Der frei gewordene Platz kann zum Einbau weiterer Komponenten genutzt werden.

In einer vorteilhaften Weiterbildung der Erfindung eignet sich das Netzteil dazu, Spannung für eine zumindest anteilige Stromversorgung wenigstens eines zweiten Servers bereitzustellen.

Bevorzugt ist der erste Server zu mindestens einem zweiten Server parallel geschaltet. Es ist demzufolge vorgesehen, die Netzteile von zumindest zwei Servern in einem Serverrack miteinander zu vernetzen.

Bei dem Ausfall eines Netzteils wird die Stromversorgung des betreffenden Servers überbrückt. Bei einer Parallelschaltung teilen sich die Ströme auf die restlichen Netzteile auf. Es ist umso vorteilhafter, je mehr Netzteile miteinander vernetzt werden, so dass bei einem Ausfall eines Netzteils der zusätzliche Strom, den jedes der restlichen Netzteile für die Überbrückung bereitstellen muss, nicht zu groß ist.

Die Vernetzung der Netzteile erfolgt in einer Ausgestaltung der Erfindung über einen Versorgungsbus, welcher in Weiterbildungen der Erfindung ein Richtsignal aussenden kann. Alternativ kann der Versorgungsbus auch als passives Teil ein Richtsignal, das von einem Master-Netzteil ausgesendet wurde, übertragen.

Gemäß einem zweiten Aspekt betrifft die Erfindung einen Server für ein Serverrack, wobei der Server ein erstes Netzteil zu einer Stromversorgung aufweist und so ausgebildet ist, dass bei einem Ausfall des ersten Netzteils die Stromversorgung des Servers durch zumindest ein zweites Netzteil erfolgen kann, welches außerhalb des Servers angeordnet ist.

Das Netzteil eignet sich bevorzugt dazu, Spannung für eine zumindest anteilige Stromversorgung mindestens einer weiteren Computereinheit bereitzustellen, welche in einem zweiten Server angeordnet ist.

Zweckmäßigerweise weist der Server zumindest einen Gleichspannungsanschluss auf, über welchen die Stromversorgung durch das zweite Netzteil erfolgen kann.

Bevorzugt weist der Server zwei Gleichspannungsanschlüsse auf, über welche die Stromversorgung durch das zweite und weitere Netzteile erfolgen kann. Besonders bevorzugt ist der Gleichspannungsanschluss oder sind die Gleichspannungsanschlüsse an einer Gehäusewandung an der Rückseite des Servers angeordnet, so dass der Server von außen kontaktiert werden kann.

Gemäß einem dritten Aspekt betrifft die Erfindung eine Anordnung mit zumindest zwei Servern gemäß einer der beschriebenen Ausbildungsformen, wobei die Server in einem Serverrack angeordnet sein können. Dabei sind die Server mittels Kabel miteinander elektrisch leitend verbunden.

In einer alternativen Ausbildung weist das Serverrack einen Stromversorgungsbus auf. In diesem Fall ist eine elektrisch leitende Verbindung jeweils zwischen den Servern und dem Stromversorgungsbus hergestellt.

Über den Stromversorgungsbus sind die Netzteile der Server miteinander verbunden.

Das Serverrack kann eine Busschiene aufweisen, welche so ausgebildet ist, dass sie den Stromversorgungsbus aufnehmen kann.

An dem Stromversorgungsbus kann ein Zusatznetzteil angeschlossen sein, welches in dem Serverrack
beispielsweise in Form eines Einschubs angeordnet sein kann. Dies ist von besonderem Vorteil, wenn die Server Leistungen von mehreren Kilowatt aufnehmen.

Gemäß einem weiteren Aspekt betrifft die Erfindung ein Netzteil zur Stromversorgung eines Servers wobei das Netzteil einen Gleichspannungsanschluss aufweist, mit welchem es an ein zweites Netzteil angeschlossen werden kann.

Gemäß einem weiteren Aspekt betrifft die Erfindung ein Serverrack, wobei im Serverrack eine Busschiene angeordnet ist, welche mit einem Stromversorgungsbus zum Anschluss im Serverrack angeordneter Server zusammenwirken kann.

Nachfolgend werden weitere Vorteile der Erfindung anhand mehrerer Ausführungsbeispiele erläutert.

### Es zeigen:

- Figur 1: eine schematische Darstellung eines Serverracks nach dem Stand der Technik,
- Figur 2: eine schematische Perspektivdarstellung zweier Server,
- Figur 3: eine Weiterbildung des Serverracks,
- Figur 4: eine alternative Weiterbildung des Serverracks,
- Figur 5a: ein Schaltbild und
- Figur 5b: eine Weiterbildung des Schaltbilds.

In den Zeichnungen sind funktionell gleiche Merkmale mit denselben Bezugszeichen versehen.

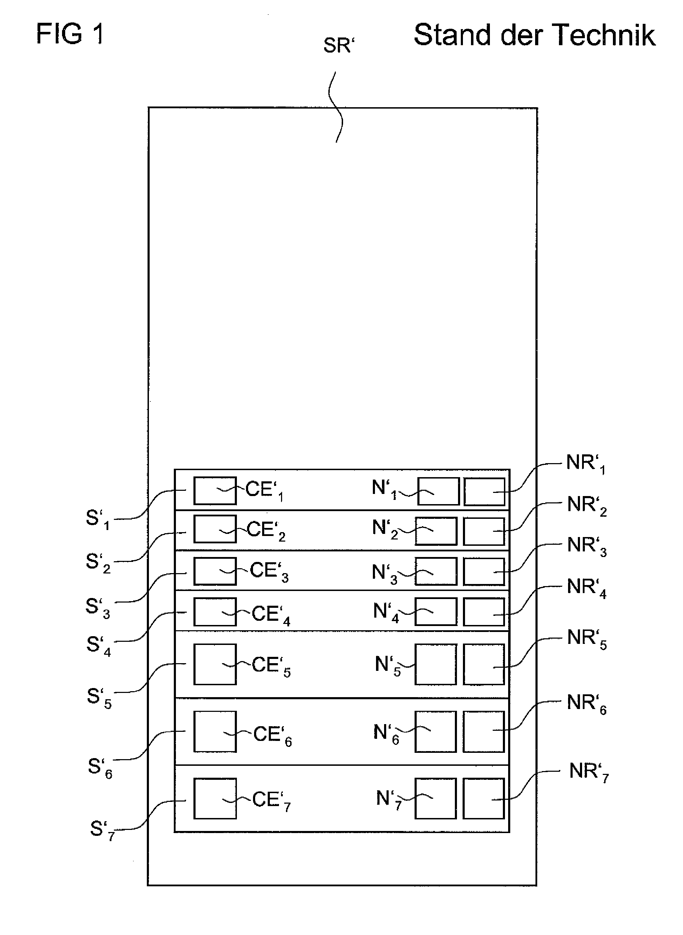

In Figur 1 ist schematisch ein Serverrack SR nach dem Stand der Technik dargestellt, welches sieben Server S₁, ..., S₇ aufweist. Die Server S_{1,} ..., S₇ sind beispielsweise 19"-Server, die in dem Serverrack SR übereinander angeordnet sind.

Die Server S₁, ..., S₇ weisen Computereinheiten CE₁, ..., CE₇ auf, Netzteile N₁, ..., N₇ sowie redundante Netzteile NR₁, ..., NR₇. Die Netzteile N₁, ..., N₇ sind als Spannungsquellen ausgebildet, welche die Computereinheiten CE₁, ..., CE₇ mit Strom versorgen. Die Netzteile N₁, ..., N₇ und die redundanten Netzteile NR₁, ..., NR₇ sind üblicherweise als AC/DC-Wandler ausgebildet, welche eine Wechselspannung aus dem 230 V Netz in eine Gleichspannung von beispielsweise 12 V, 5 V oder 3 V transformieren.

Die Stromversorgung der Computereinheiten CE₁, ..., CE₇ ist durch die Zusatznetzteile NR₁, ..., NR₇ redundant ausgelegt. Die redundanten Netzteile NR₁, ..., NR₇ werden bei einem störungsfreien Betrieb nicht benötigt. Ein redundantes Netzteil NR ist eine funktional gleiche Ressource zu einem Netzteil N, welches zur Stromversorgung eingesetzt wird. Das

Risiko eines Ausfalls eines Servers S wird bei zwei Netzteilen N und NR verringert und dementsprechend die Ausfallsicherheit erhöht.

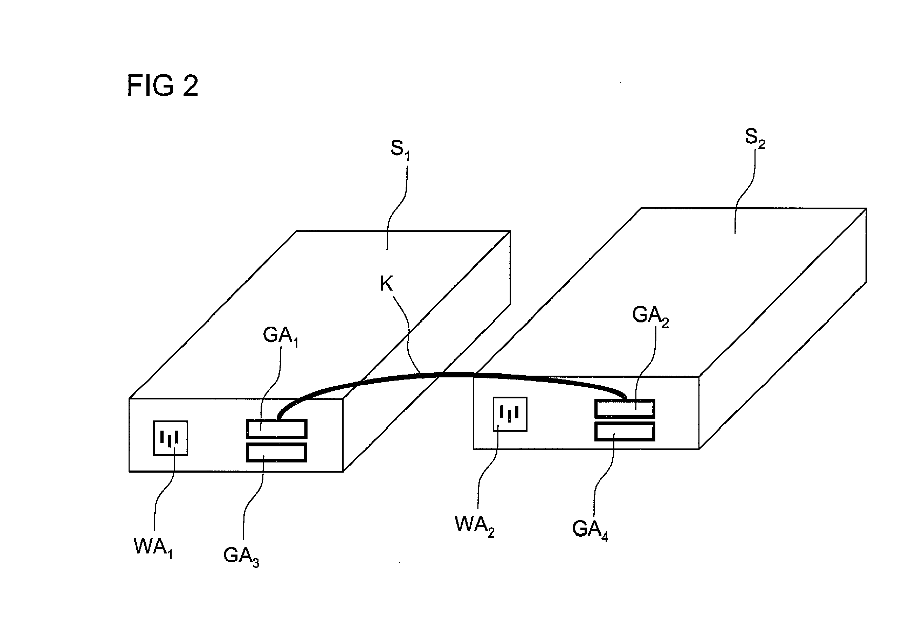

Figur 2 zeigt die zwei Server S₁ und S₂. An der Rückseite der Gehäusewandung der Server S₁ und S₂ sind Wechselspannungsanschlüsse WA₁ und WA₂, mit anderen Worten Netzanschlüsse, und Gleichspannungsanschlüsse GA₁ und GA₂ ausgebildet. Die Verbindung der Server S₁ und S₂ erfolgt durch ein Kabel K, welches den Gleichspannungsanschluss GA₁ des ersten Servers S₁ mit dem Gleichspannungsanschluss GA₂ des zweiten Servers S₂ verbindet.

Die Gleichspannungsanschlüsse GA₁ und GA₂ sind von außen kontaktierbar. Sie sind als weibliche Stecker ausgebildet.

Die Server S₁ und S₂ weisen weitere Gleichspannungsanschlüsse GA₃ und GA₄ auf, die den Gleichspannungsanschlüssen GA₁ und GA₂ entsprechen, wodurch sie mit weiteren Servern S₃ und S₄ (nicht dargestellt) verbunden sein können.

Zur Einhaltung der elektromagnetischen Verträglichkeit wird ein spezielles Kabel K verwendet. Die Kabeldicke ist dem maximal übertragbaren Strom angepasst und beispielsweise in der Dicke eines Autobatteriekabels ausgebildet.

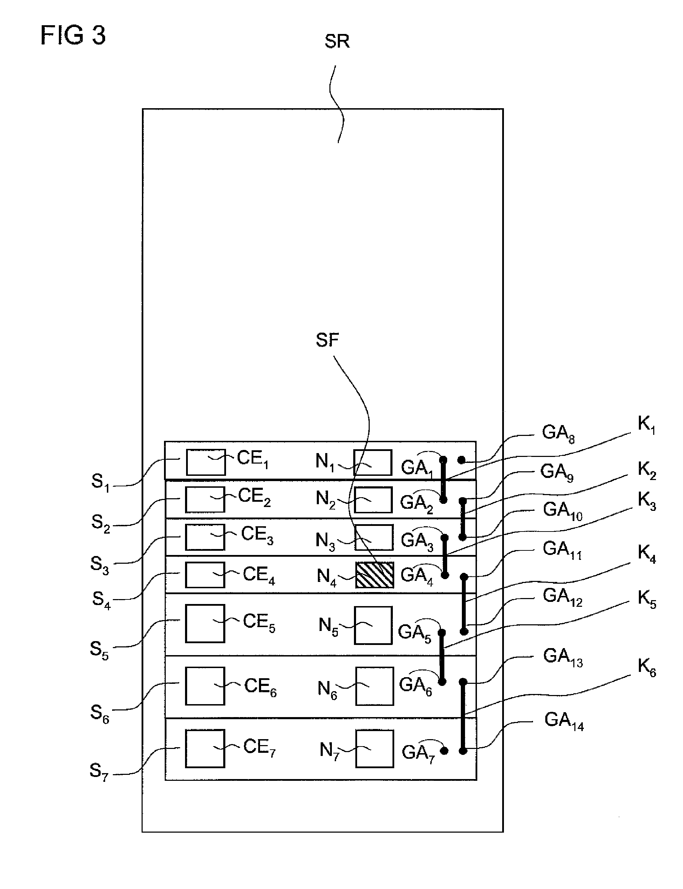

In Figur 3 ist eine erfindungsgemäße Weiterbildung des in Figur 1 dargestellten Serverracks SR gezeigt. Die Server S₁
..., S₇ weisen Gleichspannungsanschlüsse GA₁, ..., GA₇ und GA₈, ..., GA₁₄ auf. Sie sind miteinander durch Kabel K₁, ..., K₆ verbunden.

Jeder Server S ist mit seinen unmittelbaren Nachbarservern verbunden, beispielsweise ist der Server S₅ über GA₁₂ mit GA₁₁ mit dem Server S₄ verbunden und über GA₅ mit GA₆ mit dem Server S₆ verbunden.

Die Server S₁, ..., S₇ weisen DC/DC-Wandler auf (nicht dargestellt), welche die Spannung an den Gleichspannungsanschlüssen GA₁, ..., GA₇ und GA₈, ..., GA₁₄ hoch transformieren beziehungsweise herunter transformieren können, um den Stromfluss durch die Kabel K₁, ..., K₆ zu verringern

Weiterhin ist an dem Server S₄ ein Störfall SF dargestellt. Das Netzteil N₄, welches die Computereinheiten CE₄, die sich in dem Server S₄ mit Störfall SF befinden, mit Strom versorgt, ist ausgefallen. Die anderen sechs Server S₁, S₂, S₃, S₅, S₆ und S₇ übernehmen die Stromversorgung der Computereinheiten CE₄. Sie überbrücken den Ausfall des Netzteils N₄ in dem Server S₄.

Im dargestellten Ausführungsbeispiel benötigen die Computereinheiten CE₄ des Servers S₄ mit Störfall SF gleich viel Leistung wie jeweils die Computereinheiten CE der sechs weiteren dargestellten Server S₁, S₂, S₃, S₅, S₆ und S₇. Bei einem Ausfall des Netzteils N₄ in dem Server S₄ können die Netzteile N₁, N₂, N₃, N₅, N₆ und N₇ der sechs weiteren Server S₁, S₂, S₃, S₅, S₆ und S₇ jeweils ein Sechstel mehr Leistung zur Verfügung stellen, um den Ausfall des Netzteils N₄ zu überbrücken.

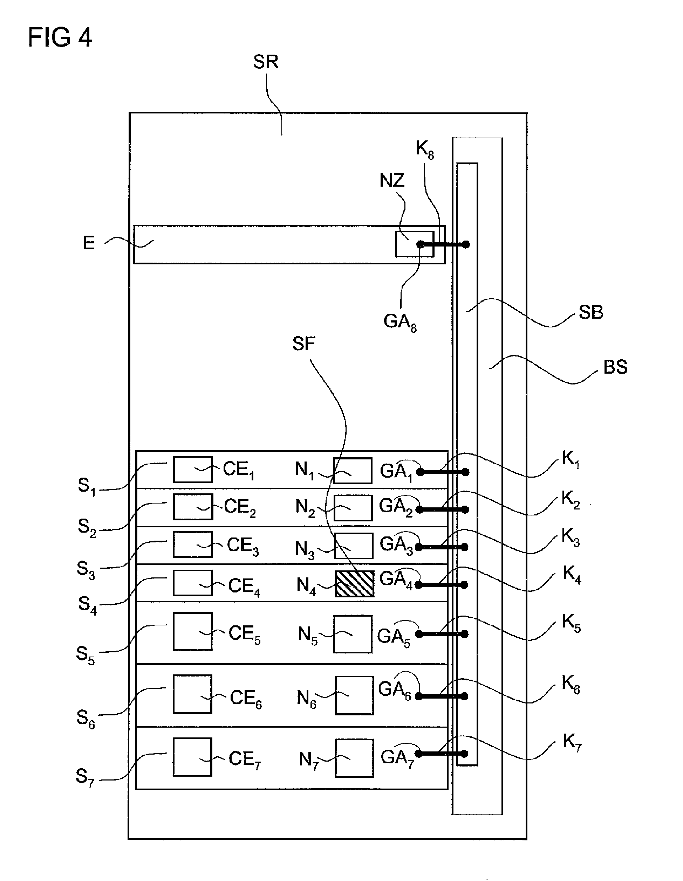

Figur 4 zeigt ein weiteres Ausführungsbeispiel der Erfindung.

Die Server S₁, ..., S₇ weisen je einen Gleichspannungsanschluss GA₁, ..., GA₇ auf. Das Serverrack SR weist eine Busschiene BS auf, in welcher ein Stromversorgungsbus SB angeordnet ist. Der Stromversorgungsbus SB ist mit den Gleichspannungsanschlüssen GA₁, ..., GA₇ der Server S₁, ..., S₇ mittels Kabel K₁, ..., K₇ elektrisch leitend verbunden.

Der Stromversorgungsbus SB weist in diesem Ausführungsbeispiel ein Zusatznetzteil NZ auf. Das Zusatznetzteil NZ ist in einem Einschub E in dem Serverrack SR angeordnet und über einen Gleichspannungsanschluss GA₈ mittels eines Kabels K₈ an den Stromversorgungsbus SB angeschlossen. Der Einschub E weist keine weiteren Computereinheiten CE auf.

Die Netzteile N₁, ..., N₇ in den Servern S₁, ..., S₇ und das Zusatznetzteil NZ stellen für die Computereinheiten CE₁, ..., CE₇ 12 V Gleichspannung zur Verfügung. In einem alternativen Ausführungsbeispiel stellt der Stromversorgungsbus SB den Servern S₁, ..., S₇ eine erhöhte Spannung zur Verfügung, beispielsweise 48 V Gleichspannung, welche in den Servern S₁, ..., S₇ durch DC/DC-Wandler auf 12 V Gleichspannung herunter transformiert wird. Die übertragenen Ströme sind bei 48 V im Falle des Ausfalls eines Netzteils N geringer, als wenn der Stromversorgungsbus SB den Servern S₁, ..., S₇ 12 V Gleichspannung zur Verfügung stellt.

In einem weiteren Ausführungsbeispiel können in dem Serverrack SB sowohl Server S mit redundanter Stromversorgung eingebaut sein als auch Server S, welche miteinander verbunden sind.

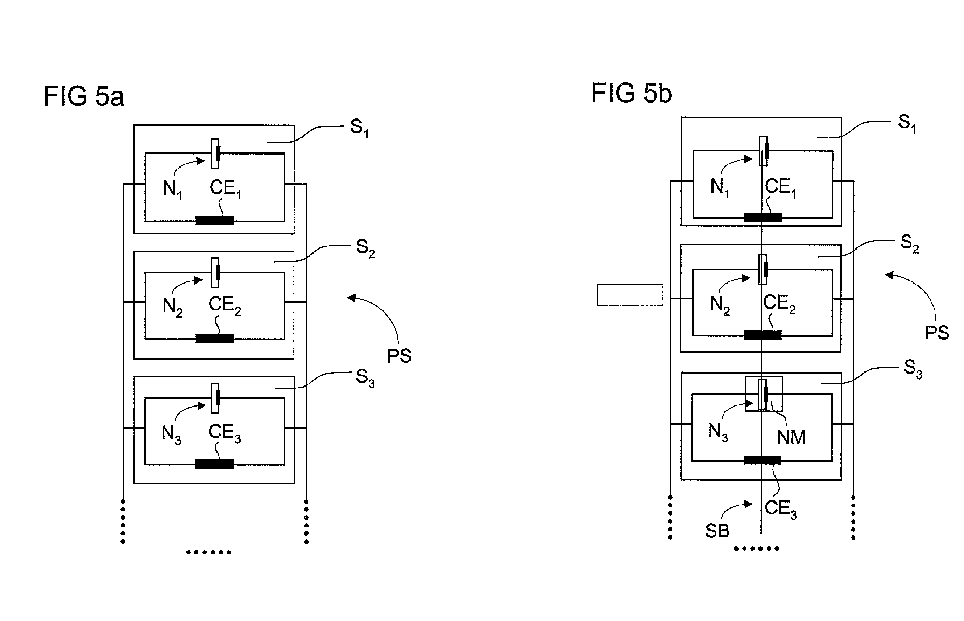

Figur 5a zeigt eine Parallelschaltung PS mit drei Servern S₁, S₂ und S₃. In den Servern S₁, S₂ und S₃ sind Computereinheiten CE₁, CE₂ und CE₃ und Netzteile N₁, N₂ und N₃ angeordnet. Durch die Punkte ist angedeutet, dass die Parallelschaltung PS durch weitere Server S₄, S₅, ... in der beschriebenen Form fortgesetzt sein kann.

In dem Ausführungsbeispiel sind baugleiche Netzteile N₁, N₂ und N₃ miteinander vernetzt, wobei baugleich bedeutet, dass die Netzteile N₁, N₂ und N₃ dieselbe Spannung und gleichermaßen viel Strom zur Verfügung stellen.

Die Computereinheiten CE₁, CE₂ und CE₃ umfassen ein oder mehrere elektronische Bauteile, wie beispielsweise CPUs, CD-ROM-Laufwerke oder Festplatten.

In Figur 5b ist die Parallelschaltung PS, welche in Figur 5a dargestellt ist, weitergebildet. Weiterhin ist schematisch der Stromversorgungsbus SB dargestellt. Der Stromversorgungsbus SB überträgt ein Richtsignal, welches die Netzteile N₁, N₂ und N₃ kalibriert, damit diese sich bei der Regelung nicht stören.

Das Netzteil N₃ ist beispielsweise hierzu als Master-Netzteil NM ausgebildet. Das Master-Netzteil NM sendet das Richtsignal an den Stromversorgungsbus SB. Das Master-Netzteil NM ist beispielsweise immer dasjenige Netzteil N, welches zuerst angeschaltet wurde.

Bezugszeichenliste
- BS: Busschiene
- CE, CE₁, CE₂,..., CE₇: Computereinheiten
- E: Einschub
- GA, GA₁, GA₂,..., GA₁₄: Gleichspannungsanschlüsse
- K, K₁, K₂,..., K₈: Kabel
- N, N₁, N₂,..., N₇: Netzteil
- NM: Master-Netzteil
- NR, NR₁, NR₂,..., NR₇: redundantes Netzteil
- NZ: Zusatznetzteil
- PS: Parallelschaltung
- S, S₁, S₂,..., S₇: Server
- SB: Stromversorgungsbus
- SR, SR: Serverrack
- WA, WA₁, WA₂: Wechselspannungsanschlüsse

## Patentansprüche

1. Verfahren zur Stromversorgung eines Servers (S₁) für ein Serverrack (SR), welcher ein erstes Netzteil (N₁) aufweist, wobei bei einem Ausfall des ersten Netzteils (N₁) die Stromversorgung des Servers (S₁) durch zumindest ein zweites Netzteil (N₂) erfolgt, welches außerhalb des Servers (S₁) angeordnet ist.

2. Verfahren nach Anspruch 1,
wobei das erste Netzteil (N₁) sich dazu eignet, Spannung für eine zumindest anteilige Stromversorgung wenigstens eines zweiten Servers (S₂) bereitzustellen.

3. Verfahren nach Anspruch 1 oder 2,
wobei der Server (S₁) zu mindestens einem zweiten Server (S₂) parallel geschaltet ist.

4. Verfahren nach einem der vorhergehenden Ansprüche,
wobei der Server (S₁) an einen Stromversorgungsbus (SB) angeschlossen ist.

5. Verfahren nach Anspruch 4,
wobei der Stromversorgungsbus (SB) ein Richtsignal aussendet.

6. Server (S₁) für ein Serverrack (SR), wobei der Server (S₁) ein erstes Netzteil (N₁) zu einer Stromversorgung aufweist und so ausgebildet ist, dass bei einem Ausfall des ersten Netzteils (N₁) die Stromversorgung des Servers (S₁) durch zumindest ein zweites Netzteil (N₂) erfolgen kann, welches außerhalb des Servers (S₁) angeordnet ist.

7. Server (S₁) nach Anspruch 6,
**dadurch gekennzeichnet, dass** das erste Netzteil (N₁) sich dazu eignet, Spannung für eine zumindest anteilige Stromversorgung wenigstens eines zweiten Servers (S₂) bereitzustellen.

8. Server (S₁) nach Anspruch 6 oder 7,
**dadurch gekennzeichnet, dass**
der Server (S₁) zumindest einen Gleichspannungsanschluss (GA₁) aufweist, über welchen die Stromversorgung des Servers (S₁) durch das zweite Netzteil (N₂) erfolgen kann.

9. Server (S₁) nach Anspruch 8,
**dadurch gekennzeichnet, dass** der Gleichspannungsanschluss (GA₁) an einer Gehäusewandung des Servers (S₁) ausgebildet ist, so dass der Server (S₁) von außen kontaktiert werden kann.

10. Anordnung mit zumindest zwei Servern (S₁, ..., S₇) nach einem der Ansprüche 6 bis 9.

11. Anordnung nach Anspruch 10,
**dadurch gekennzeichnet, dass**
die Server (S₁, ..., S₇) in einem Serverrack (SR) angeordnet sind.

12. Anordnung nach Anspruch 11,
**dadurch gekennzeichnet, dass** das Serverrack (SR) einen Stromversorgungsbus (SB) aufweist, über welchen die Netzteile (N₁, ..., N₇) der Server (S₁, ..., S₇) verbunden werden können.

13. Anordnung nach Anspruch 12,
**dadurch gekennzeichnet, dass**
das Serverrack (SR) eine Busschiene (BS) aufweist, in welchen der Stromversorgungsbus (SB) angeordnet werden kann.

14. Anordnung gemäß einem der vorherigen Ansprüche 11 bis 13,
**dadurch gekennzeichnet, dass**
an dem Stromversorgungsbus (SB) ein Zusatznetzteil (NZ) angeordnet ist.

15. Netzteil (N₁) zur Stromversorgung eines Servers (S₁) nach einem der Ansprüche 6 bis 9,
**dadurch gekennzeichnet, dass**
das Netzteil (N₁) einen Gleichspannungsanschluss (GA₁) aufweist, mit welchem es an das zweite Netzteil (N₂) angeschlossen werden kann.

16. Serverrack (SR) für eine Anordnung mit zumindest zwei Servern (S₁, ..., S₇) nach einem der Ansprüche 6 bis 9,
**dadurch gekennzeichnet, dass**
im Serverrack (SR) eine Busschiene (BS) angeordnet ist, welche mit einem Stromversorgungsbus (SB) zum Anschluss der im Serverrack (SR) angeordneten Server (S₁, ..., S₇) zusammenwirken kann.
